# EUROPÄISCHE PATENTSCHRIFT

(11) **EP 1 962 193 B1**
(45) Veröffentlichungstag und Bekanntmachung des Hinweises auf die Patenterteilung: **28.04.2010**
(21) Anmeldenummer: 08101349.2
(22) Anmeldetag: 07.02.2008
(51) Int. Cl.: G06F 11/00

(54) **Schaltungsvorrichtung und entsprechendes Verfahren zum Ansteuern einer Last**
Circuit device and corresponding method for controlling a load
Dispositif de circuit pour la commande d'une charge et procédé correspondant

(30) Priorität: 19.02.2007 DE 102007008168
(43) Veröffentlichungstag der Anmeldung: 27.08.2008
(73) Patentinhaber: Continental Automotive GmbH, 30165 Hannover (DE)
(72) Erfinder: Förstl, Bernhard, 93346, Ihrlerstein (DE)

(56) Entgegenhaltungen:
- EP-A- 0 319 799
- US-A- 4 635 223
- US-A- 5 307 409

## Beschreibung

Die vorliegende Erfindung betrifft eine Schaltungsvorrichtung zum Ansteuern einer Last insbesondere auf dem Gebiet der Kraftfahrzeugtechnik. Darüber hinaus betrifft die vorliegende Erfindung ein Steuersystem mit einer Steuereinheit und der genannten Schaltungsvorrichtung sowie ein entsprechendes Verfahren zum Ansteuern einer Last.

Gerade für sicherheitsrelevante Applikationen ist es notwendig, im Fehlerfall einen sicheren Zustand des Systems zu erreichen. In der Regel ist der Zustand, der vor dem Eintreten des Fehlers aktiv und gültig war, der sichere Zustand. Dieser Begriff des "sicheren Zustands" kann am Beispiel einer elektronischen Lenkradverriegelung wie folgt erläutert werden: War eine elektronische Lenkradverriegelung zum Zeitpunkt t1 entriegelt, d. h. die Lenkung ist freigegeben und Bolzen blockieren die Lenkung nicht, so darf im Fehlerfall unter keinen Umständen die Lenkradverriegelung aktiviert werden. War umgekehrt zum Zeitpunkt t2 die Lenkradverriegelung aktiviert, so muss sie im Fehlerfall verriegelt bleiben.

Zum einen ist es also notwendig, eine sichere Aussage über den Zustand des Systems gewinnen zu können und zum anderen muss ein derartiger sicherer Zustand des Systems auch erreicht werden. Bisher wird versucht, durch Redundanzmaßnahmen zu einer gültigen Zustandsaussage des Systems zu gelangen. In der Regel werden zwei parallele, voneinander unabhängige Zweige mit jeweils einem Mikrokontroller zum Aufbau der Redundanz verwendet.

Die EP 0 319 799 A offenbart eine sichere Schaltungsvorrichtung, wonach wenigstens drei Register sowie eine Vergleichseinrichtung der gestalt zusammen fungieren, dass eine sichere Steuerung eine Last gewährleistet wird. Diesbezüglich werden Datenwörter in ein Paar von Registern geschrieben. Eine digitale Vergleichseinrichtung bestimmt, ob die zwei Datenwörter gleich sind und initiiert einen Datentransfer in ein drittes Register zur Übertragung an Hardware-Steuerpunkte nur dann, wenn zwei gleiche aufeinanderfolgende Datenwörter erkannt werden. Wenn keine derartige Erkennung erfolgt, werden keine neuen Daten in das dritte Register übertragen.

Die Aufgabe der vorliegenden Erfindung besteht somit darin, einen sicheren Zustand eines Systems mit möglichst wenig Redundanzmaßnahmen zu erreichen.

Erfindungsgemäß wird gemäß Anspruch 1 diese Aufgabe gelöst durch eine Schaltungsvorrichtung umfassend ein erstes Register zur Aufnahme von Steuerdaten von einer externen Steuereinrichtung, ein zweites Register zur Aufnahme der gleichen Steuerdaten von der externen Steuereinrichtung, ein drittes Register zur Ausgabe von Daten an die zu steuernde Last, einer Übertragungseinrichtung zur Übertragung von Daten von dem zweiten Register zu dem dritten Register, eine erste Vergleichslogik zum Vergleichen des Inhalts des zweiten Registers mit dem des dritten Registers und zum Aussenden eines Interrupts oder Steuersignals an die externe Steuereinrichtung, wenn die beiden Inhalte nicht gleich sind, eine zweite Vergleichslogik zum Vergleichen des Inhalts des ersten Registers mit dem des zweiten Registers und zum Freigeben der Übertragungseinrichtung, wenn die Inhalte der beiden Register gleich sind, und andernfalls zum Sperren der Übertragungseinrichtung.

Darüber hinaus wird erfindungsgemäß bereitgestellt ein Steuersystem gemäß Anspruch 5 zum Ansteuern einer Last mit einer oben dargestellten Schaltungsvorrichtung und einer Steuereinrichtung, die eine erste Ausgabeschnittstelle zur Ausgabe der Steuerdaten an das erste Register, eine zweite Ausgabeschnittstelle zur Ausgabe der gleichen Steuerdaten an das zweite Register, und eine Steuersignalverarbeitungseinheit aufweist, so dass jeweils in der ersten und zweiten Ausgabeschnittstelle eine Datenausgabe initiiert wird, wenn die Steuersignalverarbeitungseinheit ein entsprechendes Interrupt oder Steuersignal von der ersten Vergleichslogik empfängt.

Ferner wird zur Lösung der oben genannten Aufgabe bereitgestellt ein Verfahren gemäß Anspruch 7 zum Ansteuern einer Last durch Vergleichen eines ersten Datensatzes eines zweiten Registers mit einem zweiten Datensatz eines dritten Registers, Ansteuern der Last mit dem zweiten Datensatz des dritten Registers, wenn der erste und der zweite Datensatz gleich sind, andernfalls Durchführen der folgenden Schritte: Überschreiben des ersten Datensatzes mit einem dritten Datensatz in einem zweiten Register, Übertragen eines vierten Datensatzes mit den gleichen Daten des dritten Datensatzes an ein erstes Register, Vergleichen der Datensätze in dem ersten Register und dem zweiten Register, Kopieren des dritten Datensatzes von dem zweiten Register in das dritte Register, wenn der dritte und der vierte Datensatz gleich sind, und Ansteuern der Last mit dem dritten Datensatz des dritten Registers, wenn der kopierte dritte Datensatz in dem dritten Register gleich dem dritten Datensatz in dem zweiten Register ist.

Vorzugsweise besitzt die oben genannte Schaltungsvorrichtung eine SPI-Schnittstelle, deren Empfangsregister das erste Register ist. Damit kann für die Schaltungsvorrichtung eine serielle Standardschnittstelle verwendet werden.

Die erfindungsgemäße Schaltungsvorrichtung kann ferner als ASIC ausgebildet sein. Damit kann eine für die Serienherstellung günstige Form der Schaltungsvorrichtung zur Verfügung gestellt werden.

Entsprechend einer besonders bevorzugten Ausführungsform weist die Schaltungsvorrichtung eine Sicherheitseinheit auf, die die Übertragungseinrichtung erst dann endgültig freigibt, wenn sie einen passenden Schlüssel von der externen Steuereinheit empfangen hat. Damit kann sichergestellt werden, dass die externe Steuereinrichtung sowie die Kommunikation zur Schaltungsvorrichtung einwandfrei funktionieren, bevor die Last mit neuen Daten angesteuert wird.

Entsprechend einer weiteren vorteilhaften Ausführungsform ist die erste Ausgabeschnittstelle seriell und die zweite Ausgabeschnittstelle parallel ausgeführt. Erst wenn die Daten über diese beiden unterschiedlichen Schnittstellen gleich übertragen sind, besteht ein hohes Maß an Sicherheit dafür, dass die Last tatsächlich mit den übertragenen Daten neu angesteuert werden soll.

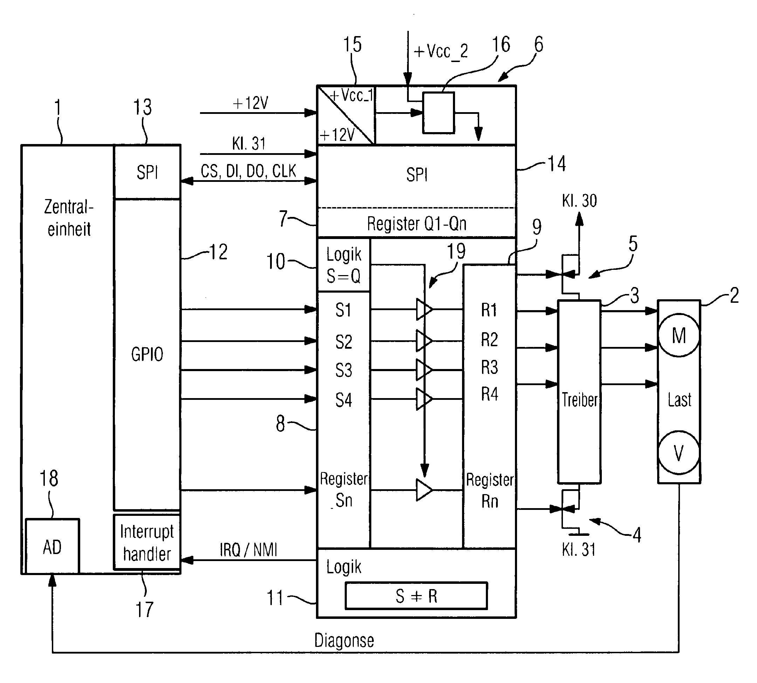

Die vorliegende Erfindung wird anhand der beigefügten Zeichnung näher erläutert, die ein Blockschaltbild eines erfindungsgemäßen Steuersystems zeigt.

Das nachfolgend näher geschilderte Ausführungsbeispiel stellt eine bevorzugte Ausführungsform der vorliegenden Erfindung dar.

Entsprechend dem in der Figur dargestellten Beispiel dient eine Zentraleinheit 1 z. B. in einem Kraftfahrzeug zur Ansteuerung einer Last 2. Die Last 2 kann beispielsweise ein Motor, ein Ventil oder dergleichen sein. Vor die Last ist in bekannter Weise ein Treiber 3 geschaltet, der die entsprechende Leistung zur Ansteuerung der Last 2 aufbringt. Er ist in ebenfalls bekannter Weise mithilfe von Schaltern 4, 5 zwischen die "Klemme 31" (Masse) und "Klemme 30" (Batteriespannung) zur Gewährleistung einer doppelten Sicherheit geschaltet.

Die Aktivierung der Last 2 erfolgt nicht direkt über die Zentraleinheit 1, die in der Regel einen Mikrokontroller aufweist, sondern über ein dazwischen geschaltetes Bauelement, hier den ASIC 6. Dieser besteht im Wesentlichen aus drei Registerblöcken 7, 8 und 9. Außerdem weist er eine erste Vergleichslogik 10 zum Vergleich des Registers 7 mit dem Register 8 und eine zweite Vergleichslogik 11 zum Vergleich des Registers 8 mit dem Register 9 auf.

Die erste Vergleichslogik 11 generiert einen Interrupt IRQ bzw. NMI oder ein entsprechendes Steuersignal immer dann, wenn die Zustände der Register 8 und 9, d. h. deren Registerinhalte S1 bis Sn und R1 bis Rn unterschiedlich sind. Das Register 8 repräsentiert die aktuellen Zustände zu einem Zeitpunkt t=t1+1. Die Daten für das Register 8 werden von der steuernden Zentraleinheit 1, die eine GPIO-Schnittstelle 12 aufweist, parallel eingeleitet.

Das Register 9 mit den Registerinhalten R1 bis Rn repräsentiert die Zustände zum Zeitpunkt t=t1 und somit die aktuelle Konfiguration, die zur entsprechenden Ansteuerung der Last 2 geführt hat. Entspricht der Zustand des Registers 8 nicht dem Zustand des Registers 9, so muss dieses Ungleichgewicht zwangsläufig durch die steuernde Zentraleinheit 1 hervorgerufen worden sein. Der generierte Interrupt Request (IRQ) des ASIC 6 startet die nachfolgende Kommunikationsroutine des ASIC 6 mit der Zentraleinheit 1:
Bei einer Ungleichheit der Registerinhalte S1 bis Sn und R1 bis Rn der Register 8 und 9 sendet also, wie erwähnt, die erste Logik 11 ein Interrupt Request (IRQ) zusammen mit einem Schlüssel (Keyword) an die Zentraleinheit 1. Ein in die Zentraleinheit integrierter Interrupthandler 17 nimmt den Interrupt Request (IRQ) auf und sorgt dafür, dass die parallele Schnittstelle GPIO 12 (General Purpose Input/Output) Daten an das Register 8 des ASIC 6 parallel überträgt. Initiiert durch den Interrupt Request (IRQ) sendet gleichzeitig eine Standardschnittstelle (SPI) 13 (Serial Peripheral Interface) die gleichen Daten D/O seriell an die entsprechende Empfangsschnittstelle 14 des ASIC 6. Mit diesen Daten DI bzw. DO werden auch Steuerbits CS (hier z. B. der Schlüssel), der mit dem Interrupt Request (IRQ) an die Zentraleinheit 1 übertragen wurde, an den ASIC 6 zurückübermittelt.

Die SPI-Schnittstelle 14 des ASIC 6 weist das oben bereits erwähnte erste Register 7 mit den Registerinhalten Q1 bis Qn auf, in dem nun die seriell empfangenen Daten gespeichert sind. Die zweite Vergleichslogik 10 vergleicht nun die Inhalte der Register 7 und 8 und überprüft den empfangenen Schlüssel. Sind die Inhalte der beiden Register 7 und 8 gleich und der Schlüssel fehlerfrei, so werden die Registerinhalte S1 bis Sn des Registers 8 mithilfe einer Treiberschaltung 19 in das Register 9 übertragen. Durch den Vergleich wird also geprüft, ob die serielle Übertragung (SPI) und die parallele Übertragung (GPIO) korrekt stattgefunden hat. D. h. die redundante Übertragung gibt Auskunft darüber, ob die Zentraleinheit 1 und der ASIC 6 fehlerfrei arbeiten. Auf diese Weise kann beispielsweise sichergestellt werden, dass die Programmsequenzen der Zentraleinheit 1 erwartungsgemäß abgearbeitet werden.

Sollte der Schlüssel fehlerhaft sein und/oder die Information im dritten Register 9 nicht mit der im zweiten Register 8 übereinstimmen, so bleibt der Zustand des Ausgangsregisters 8 unverändert. Dies bedeutet, dass das Register 8 für das Register 9 nicht transparent wird und der ursprüngliche Ansteuerzustand der Last 2 unverändert bleibt. Der zuletzt eingenommene Zustand bleibt also im Fehlerfall erhalten. Ein Fehlerfall kann beispielsweise durch einen Spannungsreset, einen Softwarefehler, durchlegierte I/O-Ports der Zentraleinheit 1, elektromagnetische Störungen etc. auftreten.

Durch die Kommunikation der Zentraleinheit 1 mit dem ASIC 6 wird die Zentraleinheit 1 erfindungsgemäß nochmals aktiv aufgefordert, die Bedingungen die zu einer Zustandsänderung führten, zu bestätigen. Ein weiterer Vorteil des erfindungsgemäßen Systems besteht in der Verwendung von Kontrollbits getrennt von Datenbits (Information). Durch diese Trennung in Verbindung mit der redundanten Übertragung kann verhindert werden, dass ein einfacher Fehler (durchlegierte Ports der Zentraleinheit 1) bereits zum undefinierten, unsicheren Systemzustand führt. Der Schlüssel wirkt also wie eine Zugriffsberechtigung auf das Ausgangsregister 9.

Der ASIC 6 kann über die geschützte "Klemme 30" mit Spannung (+12V) versorgt werden. Dazu ist in dem in der Figur dargestellten Beispiel in den ASIC 6 ein Spannungswandler 15 integriert, dessen Ausgangsspannung Vcc_1 ist. Daneben kann die Spannungsversorgung auch über eine Spannung Vcc_2 erfolgen. Eine entsprechende Logik 16 gewährleistet, dass der ASIC 6 bzw. die SPI-Schnittstelle 14 mit der Spannung Vcc_1 oder Vcc_2 versorgt wird.

Die Spannungsversorgung mit einem eigenen Spannungsregler 15 ist deswegen ohne größeren Aufwand im ASIC 6 möglich, da der Stromverbrauch, der im Wesentlichen durch die Register 7, 8, 9 bestimmt wird, sehr gering ist (in der Regel <50µA). Wegen dieses geringen Stromverbrauchs kann nämlich die Verlustleistung, die sich bei der Transformation von +12V auf +Vcc_1 (+3V/+5V) ergibt, gering gehalten werden.

Zur Diagnose wird ein Signal von der Last 2 zur Zentraleinheit 1 übertragen. Diese weist hierzu einen AD-Wandler 18 auf.

Der erfindungsgemäße ASIC stellt eine kostengünstige Alternative zu typischen Sicherheitskonzepten dar, die ausschließlich auf Redundanz beruhen, welche beispielsweise durch Programmsequenzen aufgeteilt auf mindestens zwei Mikrokontroller realisiert ist. Durch die redundante Informationsverarbeitung (parallele Verarbeitung durch GPIO und serielle Verarbeitung durch SPI) werden Einfachfehler sicher erkannt.

### Bezugszeichenliste

- 1: Zentraleinheit
- 2: Last
- 3: Treiber
- 4, 5: Schalter
- 6: ASIC
- 7, 8, 9: Register
- 10, 11: Vergleichslogik
- 12: GPIO-Schnittstelle
- 13: SPI-Schnittstelle
- 14: Empfangsschnittstelle
- 15: Spannungsregler
- 16: Logik
- 17: Steuersignalverarbeitungseinheit
- 18: AD-Wandler
- 19: Treiberschaltung, Übertragungseinrichtung
- Q1-Qn, R1-Rn, S1-Sn: Registerinhalte

## Patentansprüche

1. Schaltungsvorrichtung umfassend
- ein erstes Register (7) zur Aufnahme von Steuerdaten von einer externen Steuereinrichtung (1),
- ein zweites Register (8) zur Aufnahme der gleichen Steuerdaten von der externen Steuereinrichtung,
- ein drittes Register (9) zur Ausgabe von Daten an die zu steuernde Last,
- einer Übertragungseinrichtung (19) zur Übertragung von Daten von dem zweiten Register (8) zu dem dritten Register (9),
- eine erste Vergleichslogik (11) zum Vergleichen des Inhalts des zweiten Registers (8) mit dem des dritten Registers (9) und zum Aussenden eines Interrupts oder Steuersignals (IRQ) an die externe Steuereinrichtung (1), wenn die beiden Inhalte nicht gleich sind
- eine zweite Vergleichslogik (10) zum Vergleichen des Inhalts des ersten Registers (7) mit dem des zweiten Registers (8) und zum Freigeben der Übertragungseinrichtung (19), wenn die Inhalte der beiden Register gleich sind, und andernfalls zum Sperren der Übertragungseinrichtung (19).

2. Schaltungsvorrichtung nach Anspruch 1, die eine SPI-Schnittstelle (14) aufweist, deren Empfangsregister das erste Register (7) ist.

3. Schaltungsvorrichtung nach Anspruch 1 oder 2, die als ASIC (6) ausgebildet ist.

4. Schaltungsvorrichtung nach einem der vorhergehenden Ansprüche, die eine Sicherheitseinheit aufweist, die die Übertragungseinrichtung (19) erst dann endgültig freigibt, wenn sie einen passenden Schlüssel von der externen Steuereinrichtung (1) empfangen hat.

5. Steuersystem zum Ansteuern einer Last (2) mit
- einer Schaltungsvorrichtung nach einem der vorhergehenden Ansprüche und
- einer Steuereinrichtung (1), die
o eine erste Ausgabeschnittstelle (13) zur Ausgabe der Steuerdaten an das erste Register (7),
o eine zweite Ausgabeschnittstelle (12) zur Ausgabe der gleichen Steuerdaten an das zweite Register (8), und
o eine Steuersignalverarbeitungseinheit (17) aufweist, so dass jeweils in der ersten und zweiten Ausgabeschnittstelle (12, 13) eine Datenausgabe initiiert wird, wenn die Steuersignalverarbeitungseinheit (17) ein entsprechendes Interrupt oder Steuersignal von der ersten Vergleichslogik (11) empfängt.

6. Steuersystem nach Anspruch 5, wobei die erste Ausgangsschnittstelle (13) eine serielle und die zweite Ausgangsschnittstelle (12) eine parallele Schnittstelle ist.

7. Verfahren zum Ansteuern einer Last (2) mit der Schaltungsvorrichtung gemäß Anspruch 1 durch
- Vergleichen eines ersten Datensatzes eines zweiten Registers (8) mit einem zweiten Datensatz eines dritten Registers (9),
- Ansteuern der Last (2) mit dem zweiten Datensatz des dritten Registers (9), wenn der erste und der zweite Datensatz gleich sind, andernfalls Durchführen der folgenden Schritte:
- Überschreiben des ersten Datensatzes mit einem dritten Datensatz in dem zweiten Register (8),
- Übertragen eines vierten Datensatzes mit den gleichen Daten des dritten Datensatzes an ein erstes Register (7),
- Vergleichen der Datensätze in dem ersten Register (7) und dem zweiten Register (8),
- Kopieren des dritten Datensatzes von dem zweiten Register (8) in das dritte Register (9), wenn der dritte und der vierte Datensatz gleich sind und Aussenden eines Interrupts oder Steuersignal (IRQ) an die externe Steuereinrichtung (1) wenn die beiden Inhalte nicht gleich sind, und
- Ansteuern der Last (2) mit dem dritten Datensatz des dritten Registers (9), wenn der kopierte dritte Datensatz in dem dritten Register (9) gleich dem dritten Datensatz in dem zweiten Register (8) ist.

8. Verfahren nach Anspruch 7, wobei Daten in das zweite Register (8) parallel übertragen werden, während Daten in das erste Register (7) seriell übertragen werden.

9. Verfahren nach Anspruch 7 oder 8, wobei der dritte Datensatz von einer Steuereinrichtung (1) stammt, an die zum Initiieren des Überschreibens des ersten Datensatzes mit dem dritten Datensatz ein Interrupt oder Steuersignal (IRQ) zusammen mit einem Schlüssel übertragen wird, der zusammen mit dem vierten Datensatz an eine Kommunikationseinheit, welche mit dem ersten Register (7) verbunden ist, übertragen wird, wobei der dritte Datensatz nur dann von dem zweiten Register (8) in das dritte Register (9) kopiert wird, wenn der Schlüssel eine vorbestimmte Form bzw. einen vorbestimmten Wert besitzt.

## Claims

1. Switching device comprising
- a first register (7) for the acquisition of control data from an external control device (1),
- a second register (8) for the acquisition of the same control data from the external control device,
- a third register (9) for outputting data to the load to be controlled,
- a transmission device (19) for transmitting data from the second register (8) to the third register (9),
- a first comparison logic (11) for comparing the content of the second register (8) with that of the third register (9) and for sending an interrupt or control signal (IRQ) to the external control device (1), if the two contents are not identical,
- a second comparison logic (10) for comparing the content of the first register (7) with that of the second register (8) and for enabling the transmission device (19), if the contents of the two registers are identical, and otherwise for blocking the transmission device (19).

2. Switching device according to claim 1, which has a SPI interface (14), the receiving register of which is the first register (7).

3. Switching device according to claim 1 or 2, which is designed as an ASIC (6).

4. Switching device according to one of the preceding claims, which has a safety unit, which only then enables the transmission device (19) when it has received a suitable key from the external control device (1).

5. Control system for activating a load (2) with
- a switching device according to one of the preceding claims and
- a control device (1), which has
o a first output interface (13) for outputting the control data to the first register (7),
o a second output interface (12) for outputting the same control data to the second register (8), and
o a control signal processing unit (17), so that a data output is initiated in each instance in the first and second output interface (12, 13), when the control signal processing unit (17) receives a corresponding interrupt or control signal from the first comparison logic (11).

6. Control system according to claim 5, wherein the first output interface (13) is a serial interface and the second output interface (12) is a parallel interface.

7. Method for activating a load (2) with the switching device according to claim 1 by
- comparing a first data record of a second register (8) with a second data record of a third register (9),
- activating the load (2) with the second data record of the third register (9), if the first and second data record are identical, otherwise carrying out the following steps:
- overwriting the first data record with a third data record in the second register (8),
- transmitting a fourth data record with the same data of the third data record to a first register (7),
- comparing the data records in the first register (7) and the second register (8),
- copying the third data record from the second register (8) into the third register (9), if the third and the fourth data record are identical and sending an interrupt or control signal (IRQ) to the external control device (1) if the two contents are not identical, and
- activating the load (2) with the third data record of the third register (9), if the copied third data record in the third register (9) is identical to the third data record in the second register (8).

8. Method according to claim 7, wherein data is transmitted in parallel into the second register (8), while data is transmitted serially into the first register (7).

9. Method according to claim 7 or 8, wherein the third data record originates from a control device (1) to which, in order to initiate the overwriting of the first data record with the third data record, an interrupt or control signal (IRQ) is transmitted together with a key, which is transmitted together with the fourth data record to a communication unit, which is connected to the first register (7), wherein the third data record is only copied from the second register (8) into the third register (9), if the key has a predetermined form or a predetermined value.

## Revendications

1. Dispositif de commutation, comprenant :
- un premier registre (7) destiné à acquérir des données de commande d'un dispositif de commande externe (1),
- un deuxième registre (8) destiné à acquérir les mêmes données de commande du dispositif de commande externe,
- un troisième registre (9) destiné à délivrer des données à la charge à commander,
- un dispositif de transmission (19) destiné à transmettre des données du deuxième registre (8) au troisième registre (9),
- une première logique de comparaison (11) destinée à comparer le contenu du deuxième registre (8) à celui du troisième registre (9) et à émettre une interruption ou un signal de commande (IRQ) vers le dispositif de commande externe (1), lorsque les deux contenus ne sont pas identiques, et
- une seconde logique de comparaison (10) destinée à comparer le contenu du premier registre (7) à celui du deuxième registre (8) et à libérer le dispositif de transmission (19), si les contenus des deux registres sont identiques, et autrement à bloquer le dispositif de transmission (19).

2. Dispositif de commutation selon la revendication 1, présentant une interface SPI (14), dont le registre de réception est le premier registre (7).

3. Dispositif de commutation selon la revendication 1 ou 2, qui se présente sous la forme d'un circuit intégré spécifique à des applications ou circuit ASIC (6).

4. Dispositif de commutation selon l'une quelconque des revendications précédentes, qui présente une unité de sécurité, qui ne libère définitivement le dispositif de transmission (19) que lorsqu'elle a reçu une clé adaptée du dispositif de commande externe (1).

5. Système de commande pour commander une charge (2), comprenant :
- un dispositif de commutation selon l'une quelconque des revendications précédentes, et
- un dispositif de commande (1), qui présente
○ une première interface de sortie (13) destinée à délivrer les données de commande au premier registre (7),
○ une seconde interface de sortie (12) destinée à délivrer les mêmes données de commande au deuxième registre (8), et
○ une unité de traitement de signal de commande (17) de manière à initier une sortie de données respectivement au niveau des première et seconde interfaces de sortie (12, 13) lorsque l'unité de traitement de signal de commande (17) reçoit une interruption ou un signal de commande correspondant de la première logique de comparaison (11).

6. Système de commande selon la revendication 5, dans lequel la première interface de sortie (13) est une interface série, tandis que la seconde interface de sortie (12) est une interface parallèle.

7. Procédé de commande d'une charge (2) avec le dispositif de commutation selon la revendication 1 par
- comparaison d'un premier jeu de données d'un deuxième registre (8) avec un deuxième jeu de données d'un troisième registre (9),
- commande de la charge (2) avec le deuxième jeu de données du troisième registre (9), lorsque les premier et deuxième jeux de données sont identiques, autrement par réalisation des étapes suivantes :
- écrasement du premier jeu de données par un troisième jeu de données dans le deuxième registre (8),
- transmission d'un quatrième jeu de données avec les mêmes données du troisième jeu de données à un premier registre (7),
- comparaison des jeux de données dans le premier registre (7) et le deuxième registre (8),
- copie du troisième jeu de données du deuxième registre (8) dans le troisième registre (9), lorsque le troisième jeu de données et le quatrième jeu de données sont identiques, et émission d'une interruption ou d'un signal de commande (IRQ) vers le dispositif de commande externe (1), si les deux contenus ne sont pas identiques, et
- commande de la charge (2) avec le troisième jeu de données du troisième registre (9), si le troisième jeu de données copié dans le troisième registre (9) est identique au troisième jeu de données dans le deuxième registre (8).

8. Procédé selon la revendication 7, dans lequel des données sont transmises en parallèle au deuxième registre (8), tandis que des données sont transmises en série au premier registre (7).

9. Procédé selon la revendication 7 ou 8, dans lequel le troisième jeu de données provient d'un dispositif de commande (1), auquel est transmis(e), pour initier l'écrasement du premier jeu de données par le troisième jeu de données, une interruption ou un signal de commande (IRQ) conjointement avec une clé, qui est transmise conjointement avec le quatrième jeu de données à une unité de communication, qui est connectée au premier registre (7), lequel troisième jeu de données n'est copié du deuxième registre (8) dans le troisième registre (9) que lorsque la clé possède une forme ou une valeur prédéterminée.
